# EUROPEAN PATENT SPECIFICATION

(11) **EP 0 890 183 B1**
(45) Date of publication and mention of the grant of the patent: **31.08.2005**
(21) Application number: 97915796.3
(22) Date of filing: 18.03.1997
(51) Int. Cl.: H01L 21/00

(54) **A FIELD EFFECT TRANSISTOR OF SiC AND A METHOD FOR PRODUCTION THEREOF**
EIN FELDEFFEKTTRANSISTOR AUS SIC UND VERFAHREN ZU DESSEN HERSTELLUNG
TRANSISTOR A EFFET DE CHAMP EN SiC ET SON PROCEDE DE PRODUCTION

(30) Priority: 27.03.1996 SE 9601173
(43) Date of publication of application: 13.01.1999
(73) Proprietor: CREE, INC., Durham, NC 27703 (US)
(72) Inventor: HARRIS, Christopher, S-191 72 Sollentuna (SE); BAKOWSKI, Mietek, S-730 50 Skultuna (SE); GUSTAFSSON, Ulf, S-582 61 Linköping (SE)
(74) Representative: Olsson, Jan
(86) International application number: PCT/SE1997/000449
(87) International publication number: WO 1997/036314

(56) References cited:
- US-A- 5 397 717

## Description

### TECHNICAL FIELD OF THE INVENTION AND PRIOR ART

The present invention relates to a transistor of SiC having an insulated gate and being one of: a) a MISFET or b) an IG-BT, said transistor comprising superimposed in the order mentioned a drain, a highly doped substrate layer being: for a) of n-type and for b) of p-type, and for b) on top thereof one of: c) a highly doped n-type buffer layer or d) no such layer; a low doped n-type drift layer, a p-type base layer, a highly doped n-type source region layer and a source, said transistor further comprising an insulating layer with a gate electrode thereon arranged on top of the base layer and extending substantially laterally from at least said source region to a n-type layer being one of: e) the drift layer or f) an additional n-type layer connected to the drift layer: for, upon applying a voltage to the gate electrode, forming a conducting inversion channel extending substantially laterally in the base layer at the interface to the insulating layer for electron transport from the source to the drain, as well as a method for producing such a transistor.

Such transistors of SiC may especially be used as switching devices in power applications owing to the possibility to turn them on and off very rapidly. Such transistors made of SiC are particularly well suited for high power applications, since such applications make it possible to benefit from the superior properties of SiC in comparison with especially Si, namely the capability of SiC to function well under extreme conditions. SiC has a high thermal stability due to a large bandgap energy, such that devices fabricated from said material are able to operate at high temperatures, namely up to 1000 K. Furthermore, it has a high thermal conductivity so that SiC devices may be arranged at a high density. SiC also has a more than five times higher breakdown field than Si, so that it is well suited as a material in high power devices operating under conditions where high voltages may occur in the blocking state of a device.

An advantage of this type of MISFET and IGBT having an inversion channel extending substantially laterally is that the charge carrier mobility in such an inversion channel will be much higher than in such devices having a vertical inversion channel along a trench, since the trap density at the interface between the base layer and the insulating layer will be much lower with this location of the surface channel, since the surface of the base layer may be formed by epitaxial growth, whereas the vertical trench wall of a device with a vertical channel has to be formed by etching or the like giving rise to a higher concentration of traps. Another advantage of this type of device structure is the absence of reliability problems connected with the high electric field occuring at the trench corner of a transistor having such a trench.

MISFET is to be interpreted broadly and shall comprise every type of field effect transistor having an insulated gate, and accordingly also MOSFETs.

A transistor according to the introduction in the form of a MOSFET is known through US patent 5 397 717. However, this transistor does not make it possible to fully benefit from the excellent property of SiC to withstand high reverse voltages in the blocking state thereof, so that it will not be suited for use in high power applications. The reason for this is that the base layer of p-type has to be low doped for keeping the threshold voltage, which has to be applied on said gate for creating said inversion channel, comparatively low and by that obtain a high carrier mobility in the channel, but this low doping of the base layer will result in a depletion thereof already at a low reverse voltage, so that this device cannot withstand high reverse voltages, which occur in high power applications.

### SUMMARY OF THE INVENTION

The object of the present invention is to provide a transistor of the type defined in the introduction, through which the problem of the prior art transistor described above is solved to a large extent making it well suited for high power applications.

This object is in accordance with the invention obtained by making said p-type base layer low doped in a region next to the interface to said insulating layer at which said inversion channel is obtainable and highly doped in a region thereunder next to the drift layer.

By doping different regions of the base layer differently in this way a high channel mobility thanks to a low threshold voltage may be combined with a high breakdown voltage in the blocking state of the transistor. The region of low doping next to the interface to the insulating layer results in a low threshold voltage, i.e. a low voltage necessary to apply to the gate for creating the inversion channel and by that a high charge mobility in said channel, and the highly doped region thereunder next to the pn-junction to the drift layer will make it possible to apply high reverse voltages to the transistor without depleting the base layer and causing a breakdown of the device. Thus, this transistor will be well suited for high power applications.

According to a preferred embodiment of the invention said p-type base layer is divided into two sub-layers, a highly doped lower first base sub-layer and a low doped upper second base sub-layer on top thereof. The combination of a low threshold voltage, which means a high channel mobility, and a high breakdown voltage may in this way be advantageously obtained by making the base layer of two differently strong doped layers.

According to another preferred embodiment of the invention said transistor comprises an additional n-type layer arranged laterally of the base layer on said base layer at a lateral distance from said source region layer, said additional n-type layer extends to the drift layer so as to conduct electrons moving in said conducting inversion channel from the source region layer to the drift layer, and said additional n-type layer is highly doped. In this way a low resistance of the transistor in the on-state may be achieved at the same time as the blocking capacity thereof will be high when reverse biased.

According to a further preferred embodiment of the invention said transistor comprises an additional highly doped p-type layer on top of said base layer and located laterally at the opposite side of the source region layer with respect to said interface for forming said conducting inversion channel, and this additional p-type layer is connected to the source. In this way a good contact from the source to the p-base may be obtained. Furthermore, if the transistor is an IGBT this additional layer will collect the holes injected into said drift layer from the substrate layer as a consequence of the electron current flowing through said inversion channel and towards the drain. These holes are moving towards the source for recombining with electrons from the source.

A further object of the invention is to provide a method for producing a transistor of SiC having an insulated gate and being one of a) a MISFET and b) an IGBT, for which the drawback of the prior art transistor of this type discussed above is considerably reduced.

Such a method comprises according to the invention the steps of:
1) epitaxially growing on top of each other the following semiconductor layers of SiC: a highly doped substrate layer being: for a) of n-type and for b) of p-type, and for b) on top thereof one of: c) a highly doped n-type buffer layer or d) no such layer; and a low doped n-type drift layer,
2) implanting p-type dopants into a surface layer of said drift layer for forming a highly doped p-type first base sub-layer,
3) epitaxially growing a low doped p-type second base sub-layer on top of said first base sub-layer,
4) implanting n-type dopants into a surface layer of said second base sub-layer for forming a highly doped n-type source region layer,
5) etching away said second base sub-layer at a lateral distance from said source region layer for forming a wall extending to the drift layer,
6) implanting n-type dopants into said second base sub-layer at a lateral distance from said source region layer and in connection with said wall and into said wall for forming an additional n-type layer extending from the surface of said second base sub-layer to the drift layer,
7) applying an insulating layer with a gate electrode thereon on the second base sub-layer at least from the source region layer to said additional n-type layer and a source on said source region layer,
the steps 4) and 5) being carried out in one of the following orders: a) 4 and then 5) and b) 5) and then 4).

In this way a transistor with a lateral inversion channel well suited for high power applications thanks to a low threshold voltage in combination with a high breakdown voltage may be obtained in an advantageous way. The key to obtaining such a transistor is the combination of implanting of p-type dopants into a surface layer of the epitaxially grown drift layer for forming a highly doped p-type first base sub-layer with an epitaxial regrowth of a low doped p-type second base sub-layer on top of said first base sub-layer. Thanks to the use of this regrowth technique it will be possible to use the preferred implantation technique for obtaining the lower highly doped p-type base sub-layer without causing any damages in the upper base sub-layer, so that this may have a high quality at the interface to the insulating layer. Accordingly, this method enables the production of a transistor of this type of SiC, in which the diffusitivity of dopants is remarkably reduced in comparison to especially Si. The dopants implanted will automatically be made electrically active thanks to the high temperature used for the epitaxial growth following upon the implantation step.

Another method through which said object of the present invention may be obtained comprises the steps of:
1) epitaxially growing on top of each other the following semiconductor layers of SiC: a highly doped substrate layer being: for a) of n-type and for b) of p-type, and for b) on top thereof one of: c) a highly doped n-type buffer layer or d) no such layer; a low doped n-type drift layer, a highly doped p-type first base sub-layer and a low doped p-type second base sub-layer,
2) etching through the two base sub-layers to said drift layer for forming a wall on said two base sub-layers,
3) epitaxially growing an additional n-type layer on said wall and onto said drift layer laterally to said base sub-layers so that this additional n-type layer will have an upper surface next to said second base sub-layer at substantially the same level as the upper surface of said second base sub-layer,
4) implanting n-type dopants into a surface layer of said second base sub-layer for forming a highly doped n-type source region layer separated laterally from the additional n-type layer,
5) applying an insulating layer with a gate electrode thereon on said second base sub-layer at least from the source region layer to said additional n-type layer and a source on said source region layer,
the step 4) being carried out one of a) after steps 2) and 3), b) before steps 2) and 3) and c) after step 2) but before step 3).

By using this method a transistor of SiC having an insulated gate and being a MISFET or an IGBT with a lateral inversion channel and the same preferred characteristics as that previously mentioned may be produced. An advantage of this method with respect to the method previously defined is that the thickness of the highly doped first base sub-layer may be chosen arbitrarily as a function of the voltage which the particular transistor has to block when reverse biased.

Further advantages and preferred features of the invention will appear from the description and the other claims.

### BRIEF DESCRIPTION OF THE DRAWINGS

With reference to the appended drawings, below follows a specific description of preferred embodiments of the invention cited as examples.

In the drawings:
- Fig. 1-4: are schematic cross-section views illustrating different steps of a method for producing a MISFET shown in Fig. 4 and according to a first preferred embodiment of the invention,
- Fig. 5-8: are views corresponding to Figs. 1-4 illustrating different steps of a method for producing an IGBT shown in Fig. 4 and according to a second preferred embodiment of the invention, and
- Fig. 8-11: are schematic cross-section views illustrating different steps of a method for producing an IGBT shown in Fig. 3 and according to a third preferred embodiment of the invention.

### DETAILED DESCRIPTION OF PREFERRED EMBODIMENTS OF THE INVENTION

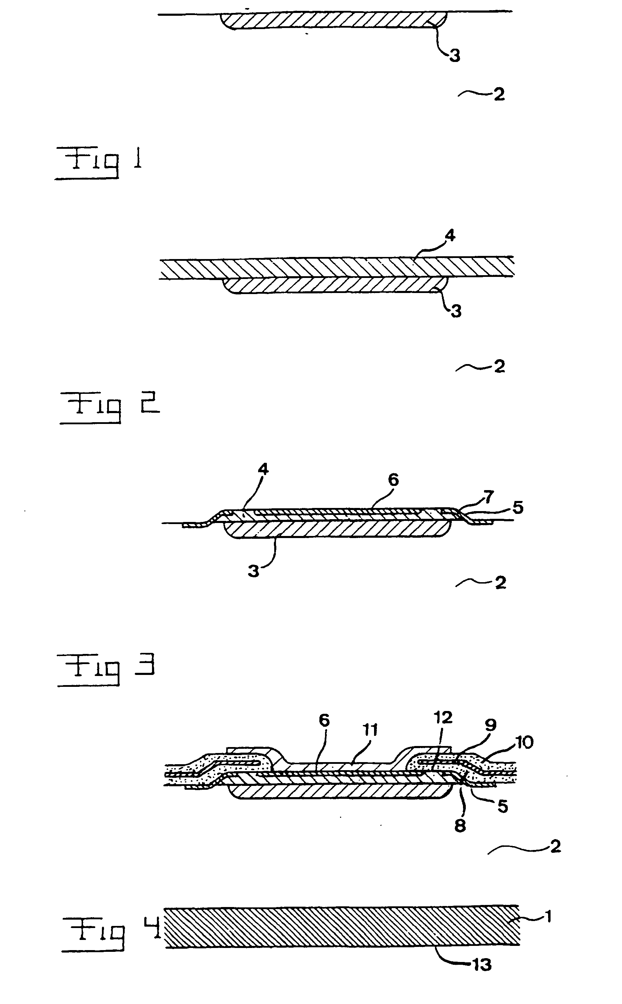

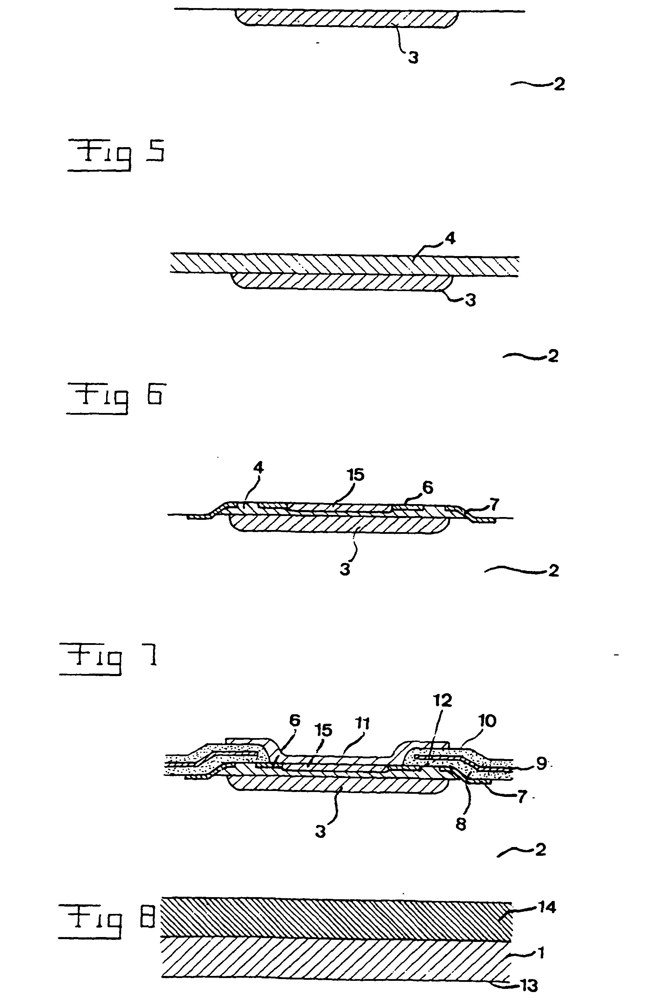

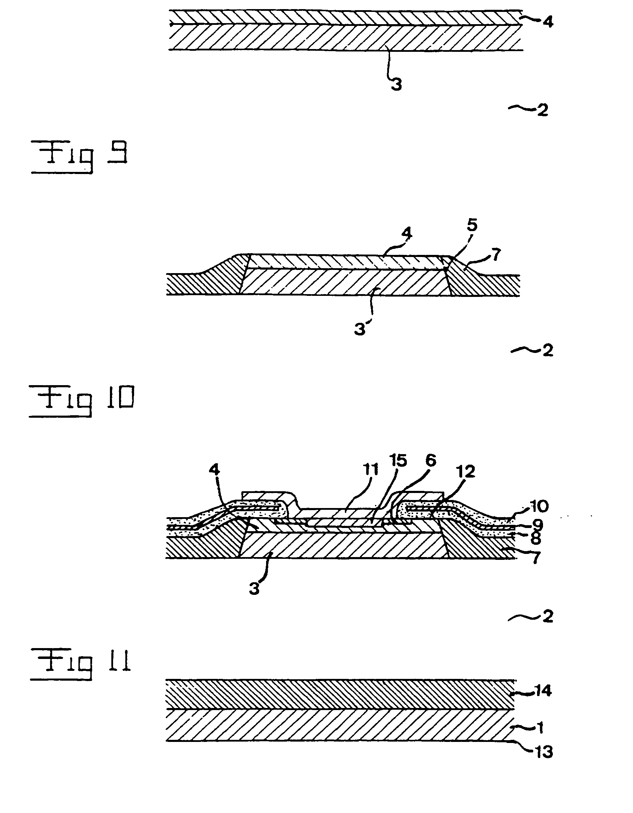

A method for producing a MISFET having a lateral conducting inversion channel will now be described with reference to Fig. 1-4. Conventional semiconductor device producing steps having nothing to do with the invention, such as masking, demasking and so on, have for the sake of clearness not been shown in the figures. First of all a highly doped n-type substrate layer 1 and on top thereof a low doped n-type drift layer 2 are epitaxially grown (see Fig. 4). After that p-type dopants, preferably aluminium or boron, but also other dopants are conceivable, are implanted into the surface layer of said drift layer for forming a highly doped p-type first base sub-layer 3. That step is followed by a step of epitaxially growth (see Fig. 2) of a low doped p-type second base sub-layer 4 on top of said first base sub-layer. This epitaxial growth is preferably carried out by using the Chemical Vapour Deposition technique at a high temperature, preferably above 1500°C, and an annealing of the implanted layer 3 for making the dopants implanted electrically active may be carried out in connection therewith by raising the temperature to 1700°C or more.

After that a MESA etch is carried out in said second base sub-layer 4 for forming a wall 5 extending to the drift layer 2. Then are n-type dopants implanted into the surface layer of said second base sub-layer 4 for forming a highly doped n-type source region layer 6 and n-type dopants are implanted into the second base sub-layer 4 at a lateral distance from the source region layer and in connection with said wall and into said wall for forming an additional n-type highly doped layer 7 extending from the surface of second base sub-layer 4 to the drift layer 2. This step is followed by an annealing step for making said n-type dopants implanted electrically active.

An insulating layer 8, for instance of SiO₂, with a gate electrode 9 thereon is applied on the second base sub-layer 4 at least from the source region layer 6 to said additional n-type layer 7. Said gate electrode is preferably of polycrystalline silicon. After that a passivating additional insulating layer 10 is applied over the gate electrode and the upper surface of the device leaving an area of said source region layer 6 exposed, and a source 11 is then applied on the layer 6.

This device will function in the following way: When a voltage is applied on the gate electrode 9 a lateral conducting inversion channel will be created at the interface 12 between said second base sub-layer and the insulating layer 8 between the source region layer 6 and said additional n-type layer 7, so that, provided that a voltage is applied over the source 11 and a drain 13, only indicated through a line, in the forward direction of the device an electron current will flow from the source to the drain. By making the base layer of two differently strong doped layers in this way a high channel mobility thanks to a low threshold voltage may be combined with a high breakdown voltage in the blocking state of the device. The second base sub-layer 4 having a low doping, which typically but not always means in the range of 10¹⁵-10¹⁸ cm⁻³, next to the interface to the insulating layer 8 results in a low threshold voltage, i.e. a low voltage necessary to apply on the gate electrode for creating the inversion channel and by that a high charge mobility in said channel, and the highly doped, which typically but not always means a doping concentration of 10¹⁹ cm⁻³ - 10²¹ cm⁻³, first base sub-layer 3 thereunder next to the pn-junction to the drift layer will make it possible to apply high reverse voltages to the device without depleting the base layer and causing a breakdown of the device. This preferred structure was possible to obtain for SiC by using the technique for epitaxial regrowth after implantation.

Fig. 5-8 illustrates the different steps for producing an IGBT (insulated gate bipolar transistor) according to a second preferred embodiment of the invention, and this method comprises the same steps as the method described above with reference to Fig. 1-4 except for the initial growth of a highly doped p-type substrate layer 1 and a highly doped n-type buffer layer 14 on top thereof, and the additional step of implanting p-type dopants into a surface layer of said second base sub-layer 4 for forming an additional highly doped p-layer 15 located laterally at the opposite side of the source region layer 6 with respect to said wall 5. The source or the cathode 11 is applied in contact also with this additional p-type layer. In this way a good contact from the source to the p-base may be obtained. Furthermore, this additional layer will collect the holes injected into said drift layer 2 from the substrate layer 1 as a consequence the electron current flowing through said inversion channel and towards the drain in an on-state of the IGBT. A MISFET could also be produced according to the steps shown in Fig. 5-8, but then without said buffer layer and with highly doping of the substrate layer with n-type dopants.

A method for producing an IGBT having a lateral conducting inversion channel according to a third preferred embodiment of the invention is illustrated in Fig. 9-11, and this method may also be used for producing a MISFET by the same changes in process steps as just described with respect to Fig. 5-8. First of all the following semiconductor layers of SiC are epitaxially grown on top of each other: a highly doped p-type substrate layer 1, a highly doped n-type buffer layer 15 (this layer is optional), a low doped n-type drift layer 2, a highly doped p-type first base substrate layer 3 and a low doped p-type second base sub-layer 4. By producing the highly doped p-type first base sub-layer 3 through epitaxial growth it will be possible to make it just as thick as desired depending on the magnitude of the voltage to be held by the device in the blocking state thereof.

After that a MESA-etch is carried out through the two base sub-layers to said drift layer for forming a wall 5 of said two base sub-layers. An additional n-type layer 7 is then epitaxially grown on said wall and onto said drift layer 2 laterally to said base sub-layers so that this additional n-type layer will have an upper surface next to said second base sub-layer at substantially the same level as the upper surface of said second base sub-layer. This step is followed by a conventional planarisation step for removing the part being grown on top of the second base sub-layer. Then n-type dopants are implanted into the surface layer of the second base sub-layer for forming a highly doped n-type source region layer 6 separated laterally from the additional n-type layer 7. P-type dopants are implanted into a surface layer of said second base sub-layer for forming an additional highly doped p-type layer 15 located laterally at the opposite side of the source region layer with respect to said wall. Finally, an insulating layer 8, a gate electrode 9, an additional insulating layer 10 and a source 11 are applied in the same way as described above for the other two methods according to the invention. This device shown in Fig. 11 will have the same function as the device shown in Fig. 8, but said highly doped first base sub-layer 3 may be maid thicker as a consequence of the different production steps.

The highly doped p-type additional layer 15 may be omitted when a MISFET is produced in this way.

The invention is of course not in any way restricted to the preferred embodiments described above, but many possibilities to modification thereof would be apparent for a man skilled in the art without departing from the basic idea of the invention.

It is emphasised that the thicknesses of different layers in the figures can not be interpreted as limiting the scope of protection, but any thickness relations are intended to be covered by the claims.

The dopants used may be of any material suitable as dopants for this application.

It is well possible to make said additional n-type layer forming a connection between the inversion channel created and the drift layer moderately or low doped, but the on-state losses will be reduced when it is highly doped.

The number of layers mentioned in the claims is a minimum number, and it is within the scope of the invention to arrange further layers in the device or dividing any layer into several layers by selective doping of different regions thereof.

"Substrate layer" is in this disclosure to be interpreted as the layer closest to the drain of the layers mentioned and it has not to be a substrate layer in the strict sense of this word within this field, i.e. the layer from which the growth is started. The real substrate layer may be any of the layers and is mostly the thickest one, which may be the drift layer.

The method claims are to be interpreted as not restricted to a growth of the layers located on top of each other in the order they are mentioned, but any other order of growth of these layers is within the scope of the claims. For instance, the method may be started from the drift layer and the so called substrate layer and the drain may be grown at the very end of the method.

## Claims

1. A transistor of SiC having an insulated gate and being one of:
a) a MISFET or
b) an IGBT;
said transistor comprising superimposed in the order mentioned a drain (13), a highly doped substrate layer (1) being:
for a) of n-type and
for b) of p-type, and for b) on top thereof one of:
c) a highly doped n-type buffer layer (14) or
d) no such layer;
a low doped n-type drift layer (2), a p-type base layer (3, 4), a highly doped n-type source region layer (6) and a source (11), said transistor further comprising an insulating layer (8) with a gate electrode (9) thereon arranged on top of the base layer and extending substantially laterally from at least said source region layer to a n-type layer being one of:
e) the drift layer or
f) an additional n-type layer (7) connected to the drift layer;
whereby upon applying of a voltage to the gate electrode a conducting inversion channel is formed extending substantially laterally in the base layer at the interface (12) to the insulating layer for electron transport from the source to the drain, **characterized in that** said p-type base layer is low doped in a region (4) next to the interface to said insulating layer at which said inversion channel is obtainable and highly doped in a region (3) thereunder next to the drift layer (2).

2. A transistor according to claim 1, **characterized in that** said p-type base layer is divided into two sub-layers, a highly doped lower first base sub-layer (3) and a low doped upper second base sub-layer (4) on top thereof.

3. A transistor according to claim 1 or 2, **characterized in that** said source region layer (6) is partially immersed into said base layer, so that the upper surface thereof is at the same level as the surface of the base layer at said interface (12) to the insulating layer (8).

4. A transistor according to any of claims 1-3, **characterized in that** it comprises an additional n-type layer (7) arranged laterally on the base layer (3, 4) on said base layer at a lateral distance from said source region layer (6), that said additional n-type layer extends to the drift layer (2) so as to conduct electrons moving in said conducting inversion channel from the source region layer to the drift layer, and that said additional n-type layer is highly doped.

5. A transistor according to any of claims 1-4, **characterized in that** it comprises an additional highly doped p-type layer (15) on top of said base layer (3, 4) and located laterally at the opposite side of the source region layer (6) with respect to said interface (12) for forming said conducting inversion channel, and that this additional p-type layer is in contact with the source (11).

6. A method for producing a transistor of SiC having an insulated gate and being one of:
a) a MISFET or
b) an IGBT; comprising the steps of:
1) epitaxially growing on top of each other the following semiconductor layers of SiC: a highly doped substrate layer (1) being:
for a) of n-type and
for b) of p-type, and for b) on top thereof one of:
c) a highly doped n-type buffer layer (14) or
d) no such layer; and a low doped n-type drift layer (2),
2) implanting p-type dopants into a surface layer of said drift layer for forming a highly doped p-type first base sub-layer (3),
3) epitaxially growing a low doped p-type second base sub-layer (4) on top of said first base sub-layer,
4) implanting n-type dopants into a surface layer of said second base sub-layer for forming a highly doped n-type source region layer (6),
5) etching away said second base sub-layer at a lateral distance from said source region layer for forming a wall (5) extending to the drift layer,
6) implanting n-type dopants into said second base sub-layer at a lateral distance from said source region layer and in connection with said wall and into said wall for forming an additional n-type layer (7) extending from the surface of said second base sub-layer to the drift layer,
7) applying an insulating layer (8) with a gate electrode (9) thereon on the second base sub-layer (4) at least from the source region layer to said additional n-type layer and a source (11) on said source region layer,
the steps 4) and 5) being carried out in one of the following orders: a) 4) and then 5) and b) 5) and then 4).

7. A method according to claim 6, **characterized in that** the etching step 5) is carried out before step 4) and the implantations according to step 4) and 6) are carried out at the same time as one single process step.

8. A method for producing a transistor of SiC having an insulated gate and being one of:
a) a MISFET or
b) an IGBT; comprising the steps of:
1) epitaxially growing on top of each other the following semiconductor layers of SiC: a highly doped substrate layer (1) being:
for a) of n-type and
for b) of p-type, and for b) on top thereof one of:
c) a highly doped n-type buffer layer (14) or
d) no such layer; a low doped n-type drift layer (2), a highly doped p-type first base sub-layer (3) and a low doped p-type second base sub-layer (4),
2) etching through the two base sub-layers to said drift layer for forming a wall (5) on said two base sub-layers,
3) epitaxially growing an additional n-type layer (7) on said wall and onto said drift layer laterally to said base sub-layers so that this additional n-type layer will have an upper surface next to said second base sub-layer at substantially the same level as the upper surface of said second base sub-layer,
4) implanting n-type dopants into a surface layer of said second base sub-layer (4) for forming a highly doped n-type source region (6) layer separated laterally from the additional n-type layer (7),
5) applying an insulating layer (8) with a gate electrode (9) thereon on said second base sub-layer at least from the source region layer to said additional n-type layer and a source (11) on said source region layer,
the step 4) being carried out one of a) after steps 2) and 3), b) before steps 2) and 3) and c) after step 2) but before step 3).

9. A method according to any of claims 6-8, **characterized in that** said additional n-type layer (7) is made highly doped when created.

10. A method according to any of claims 6-9, **characterized in that** it comprises the step of implanting p-type dopants into a surface layer of said second base sub-layer (4) for forming an additional highly doped p-type layer (15) located laterally at the opposite side of the source region layer with respect to said wall, and that the source (11) is applied also in contact with this additional p-type layer.

11. A method according to any of claims 6-9, **characterized in that** it comprises the step of etching through said second base sub-layer (4) to the first one (3) laterally at the opposite side of the source region layer with respect to said wall, and that the source (11) is applied also in contact with the first base sub-layer in this trench.

12. A method according to claim 6, **characterized in that** one of a) boron and b) aluminium is implanted as p-type dopant in step 2).

## Patentansprüche

1. Transistor aus SiC, der ein isoliertes Gate aufweist und bei dem es sich entweder um
a) einen MISFET oder
b) einen IGBT handelt;
wobei der Transistor in der angegebenen Reihenfolge übereinander liegend eine Drain (13), eine hochdotierte Substratschicht (1), welche
im Falle von a) n-leitend und
im Falle von b) p-leitend ist, sowie im Falle von b) auf letzterer:
c) eine hochdotierte n-leitende Pufferschicht (14) oder
d) keine solche Schicht;
eine niedrigdotierte n-leitende Driftschicht (2), eine p-leitende Basisschicht (3, 4), eine hochdotierte n-leitende Sourcegebiet-Schicht (6) und eine Source (11) umfasst, wobei der Transistor weiterhin eine mit einer darauf befindlichen Gate-Elektrode (9) versehene Isolierschicht (8) umfasst, welche auf der Basisschicht angeordnet ist und sich im wesentlichen seitlich wenigstens von der Sourcegebiet-Schicht bis zu einer n-leitenden Schicht erstreckt, bei der es sich entweder
e) um die Drift-Schicht oder
f) um eine zusätzliche n-leitende Schicht (7) handelt, die mit der Drift-Schicht verbunden ist;
wodurch bei Anlegen einer Spannung an die Gate-Elektrode ein leitender Inversionskanal gebildet wird, der sich im wesentlichen seitlich in der Basisschicht an der Grenzfläche (12) bis zu der Isolierschicht erstreckt und dem Elektronentransport von der Source zur Drain dient, **dadurch gekennzeichnet, dass** die p-leitende Basisschicht in einem Gebiet (4) an der Grenzfläche zur Isolierschicht, an der der Inversionskanal gebildet werden kann, niedrig dotiert ist und dass sie in einem darunter liegenden Gebiet (3), das an die Drift-Schicht angrenzt, hochdotiert ist.

2. Transistor nach Anspruch 1, **dadurch gekennzeichnet, dass** die p-leitende Basisschicht in zwei Teilschichten unterteilt ist, einer unteren, hochdotierten ersten Basis-Teilschicht (3) und einer oberen, niedrigdotierten zweiten Basis-Teilschicht (4), die auf der ersteren angeordnet ist.

3. Transistor nach Anspruch 1 oder 2, **dadurch gekennzeichnet, dass** die Sourcegebiet-Schicht (6) teilweise in der Basisschicht versenkt ist, so dass sich ihre obere Fläche auf demselben Niveau befindet wie die Oberfläche der Basisschicht an der Grenzfläche (12) zur isolierenden Schicht (8).

4. Transistor nach einem der Anspruche 1-3, **dadurch gekennzeichnet, dass** er eine zusätzliche n-leitende Schicht (7) umfasst, die seitlich auf der Basisschicht (3, 4) in einem seitlichen Abstand von der Sourcegebiet-Schicht (6) angeordnet ist, dass sich die zusätzliche n-leitende Schicht bis zu der Drift-Schicht (2) erstreckt, so dass sie Elektronen leitet, die sich in dem leitenden Inversionskanal von der Sourcegebiet-Schicht zu der Drift-Schicht bewegen, und dass die zusätzliche n-leitende Schicht hochdotiert ist.

5. Transistor nach einem der Ansprüche 1-4, **dadurch gekennzeichnet, dass** er eine zusätzliche hochdotierte p-leitende Schicht (15) umfasst, die sich auf der Basisschicht (3, 4) und in Bezug auf die Grenzfläche (12) seitlich an der gegenüberliegenden Seite der Sourcegebiet-Schicht (6) befindet und der Bildung des leitenden Inversionskanals dient, und dass diese zusätzliche p-leitende Schicht mit der Source (11) in Kontakt ist.

6. Verfahren zur Herstellung eines Transistors aus SiC, der ein isoliertes Gate aufweist und bei dem es sich entweder um
a) einen MISFET oder um
b) einen IGBT handelt;
umfassend die Schritte:
1) epitaktisches Aufwachsen lassen der folgenden SiC-Halbleiterschichten übereinander: eine hochdotierte Substratschicht (1), welche
im Falle von a) n-leitend und
im Falle von b) p-leitend ist, sowie im Falle von b) auf dieser Schicht entweder:
c) eine hochdotierte n-leitende Pufferschicht (14) oder
d) keine solche Schicht; und eine niedrigdotierte n-leitende Drift-Schicht (2),
2) Implantieren eines p-leitenden Dotierungsmaterials in eine Oberflächenschicht der Drift-Schicht, um eine hochdotierte p-leitende erste Basis-Teilschicht (3) zu bilden,
3) epitaktisches Aufwachsen lassen einer niedrigdotierten p-leitenden zweiten Basis-Teilschicht (4) auf der ersten Basis-Teilschicht,
4) Implantieren von n-leitenden Dotierungsmaterialien in eine Oberflächenschicht der zweiten Basis-Teilschicht, um eine hochdotierte n-leitende Sourcegebiet-Schicht (6) zu bilden,
5) Wegätzen der zweiten Basis-Teilschicht in einem seitlichen Abstand von der Sourcegebiet-Schicht, um eine Wand (5) zu bilden, die sich bis zur Drift-Schicht erstreckt,
6) Implantieren von n-leitenden Dotierungsmaterialien in die zweite Basis-Teilschicht in einem seitlichen Abstand von der Sourcegebiet-Schicht und in Verbindung mit der Wand und in die Wand hinein, um eine zusätzliche n-leitende Schicht (7) zu bilden, die sich von der Oberfläche der zweiten Basis-Teilschicht zur Drift-Schicht erstreckt,
7) Aufbringen einer isolierenden Schicht (8) mit einer darauf befindlichen Gate-Elektrode (9) auf die zweite Basis-Teilschicht (4), und zwar wenigstens von der Sourcegebiet-Schicht zu der zusätzlichen n-leitenden Schicht, und einer Source (11) auf die Sourcegebiet-Schicht,
wobei die Schritte 4) und 5) in einer der nachfolgend aufgeführten Reihenfolgen durchgeführt werden: a) 4) und dann 5), und b) 5) und dann 4).

7. verfahren nach Anspruch 6, **dadurch gekennzeichnet, dass** der Ätzschritt 5) vor Schritt 4) ausgeführt wird und dass die Implantierungen gemäß Schritt 4) und 6) gleichzeitig, als ein einziger Verfahrensschritt, ausgeführt werden.

8. Verfahren zur Herstellung eines Transistors aus SiC, der ein isoliertes Gate aufweist und bei dem es sich entweder um
a) einen MISFET oder
b) einen IGBT handelt; umfassend die Schritte:
1) epitaktisches Aufwachsen der folgenden SiC-Halbleiterschichten übereinander: eine hochdotierte Substratschicht (1), welche
im Falle von a) n-leitend und
im Falle von b) p-leitend, sowie im Falle von b) auf dieser Schicht entweder:
c) eine hochdotierte n-leitende Pufferschicht (14) oder
d) keine solche Schicht; und eine niedrigdotierte n-leitende Drift-Schicht (2), eine hochdotierte p-leitende erste Basis-Teilschicht (3) und eine niedrigdotierte p-leitende zweite Basis-Teilschicht (4),
2) Durchätzen der beiden Basis-Teilschichten bis zu der Drift-Schicht, um auf den beiden Basis-Teilschichten eine Wand (5) zu bilden
3) epitaktisches Aufwachsen lassen einer zusätzlichen n-leitenden Schicht (7) auf der Wand und auf der Drift-Schicht, und zwar seitlich von den Basis-Teilschichten, so dass diese zusätzliche n-leitende Schicht eine obere Fläche aufweist, die neben der zweiten Basis-Teilschicht im Wesentlichen auf demselben Niveau wie die obere Fläche der zweiten Basis-Teilschicht liegt,
4) Implantieren eines n-leitenden Dotierungsmittels in eine Oberflächenschicht der zweiten Basis-Teilschicht (4), um eine hochdotierte n-leitende Sourcegebiet-Schicht (6) zu bilden, welche seitlich von der zusätzlichen n-leitenden Schicht (7) getrennt ist,
5) Aufbringen einer isolierenden Schicht (8) mit einer darauf befindlichen Gate-Elektrode (9) auf die zweite Basis-Teilschicht, und zwar wenigstens von der Sourcegebiet-Schicht zu der zusätzlichen n-leitenden Schicht, und einer Source (11) auf die Sourcegebiet-Schicht,
wobei der Schritt 4) in einer der nachfolgend aufgeführten Abfolgen durchgeführt wird: a) nach den Schritten 2) und 3), b) vor den Schritten 2) und 3), und c) nach Schritt 2) jedoch vor Schritt 3).

9. Verfahren nach einem der Ansprüche 6-8, **dadurch gekennzeichnet, dass** die zusätzliche n-leitende Schicht (7) während ihrer Erzeugung hoch dotiert wird.

10. Verfahren nach einem der Ansprüche 6-9, **dadurch gekennzeichnet, dass** es die Schritte des Implantierens von p-leitenden Dotierungsmaterialien in eine Oberflächenschicht der zweiten Basis-Teilschicht (4) umfasst, um eine zusätzliche hochdotierte p-leitende Schicht (15) zu bilden, welche sich seitlich an der in Bezug auf die Wand gegenüberliegenden Seite der Sourcegebiet-Schicht befindet, und dass die Source (11) in Kontakt mit dieser zusätzlichen p-leitenden Schicht aufgebracht wird.

11. Verfahren nach einem der Ansprüche 6-9, **dadurch gekennzeichnet, dass** es den Schritt des Durchätzens der zweiten Basis-Teilschicht (4) bis zur ersten (3) umfasst, und zwar seitlich an der in Bezug auf die Wand gegenüberliegenden Seite der Sourcegebiet-Schicht, und dass die Source (11) in diesem Graben in Kontakt mit der ersten Basis-Teilschicht aufgebracht ist.

12. Verfahren nach Anspruch 6, **dadurch gekennzeichnet, dass** in Schritt 2) entweder a) Bor oder b) Aluminium als p-leitendes Dotierungsmaterial implantiert wird.

## Revendications

1. Transistor de SiC présentant une porte isolée et étant :
a) un MISFET ou
b) un IGBT,
ledit transistor comprenant superposés dans l'ordre mentionné un drain (13), une couche de substrat fortement dopée (1) étant :
pour a) du type N et
pour b) de type P, et pour b) sur le dessus de celui-ci :
c) une couche tampon de type N fortement dopée (14) ou
d) pas de telle couche,
une couche de dérivation de type N faiblement dopée (2), une couche de base de type P (3, 4), une couche de région source de type N fortement dopée (6) et une source (11), ledit transistor comprenant encore une couche isolante (8) avec une électrode de porte (9) ainsi disposée sur le dessus de la couche de base et s'étendant sensiblement latéralement depuis au moins ladite couche de région source, jusqu'à une couche de type N choisie parmi :
e) la couche de dérivation ou
f) une couche supplémentaire de type N (7) connectée à la couche de dérivation;
où l'application d'une tension à l'électrode de porte forme un canal d'inversion conducteur s'étendant sensiblement latéralement dans la couche de base à l'interface (12) de la couche isolante pour le transport d'électron depuis la source jusqu'au drain, **caractérisé en ce que** ladite couche de base de type P est faiblement dopée dans une région (4) proche de l'interface de ladite couche isolante où ledit canal d'inversion peut être obtenu et fortement dopée dans une région (3) proche de la couche de dérivation (2).

2. Transistor selon la revendication 1, **caractérisé en ce que** ladite couche de base de type P est divisée en deux sous-couches, une première sous-couche de base inférieure fortement dopée (3) et une seconde sous-couche de base supérieure faiblement dopée (4) au-dessus de la première.

3. Transistor selon la revendication 1 ou 2, **caractérisé en ce que** ladite couche de région source (6) est partiellement plongée dans ladite couche de base, afin que la surface supérieure de celle-ci soit au même niveau que la surface de la couche de base à l'endroit de ladite interface (12) avec la couche isolante (8).

4. Transistor selon l'une quelconque des revendications 1 à 3, **caractérisé en ce qu'**il comprend une couche supplémentaire de type N (7) disposée latéralement sur la couche de base (3, 4) sur la couche de base à une distance latérale de ladite couche de région source (6), et **en ce que** ladite couche supplémentaire de type N s'étend jusqu'à la couche de dérivation (2) afin de conduire les électrons se déplaçant dans ledit canal d'inversion conducteur depuis la couche de région source jusqu'à la couche de dérivation, et **en ce que** ladite couche supplémentaire de type N est fortement dopée.

5. Transistor selon l'une quelconque des revendications 1 à 4, **caractérisé en ce qu'**il comprend une couche supplémentaire de type P fortement dopée (15) au-dessus de ladite couche de base (3, 4) et située latéralement du côté opposé à la couche de région source (6) relativement à ladite interface (12) pour former ledit canal d'inversion conducteur, et **en ce que** cette couche supplémentaire de type P est en contact avec la source (11).

6. Procédé de fabrication d'un transistor de SiC présentant une porte isolée et étant :
a) un MISFET ou
b) un IGBT;
comprenant les étapes de :
1) croissance épitaxiale sur l'une et l'autre des couches semi-conductrices de SiC suivantes : une couche de substrat fortement dopée (1) étant :
pour a) de type N et
pour b) de type P, et pour b) au-dessus de laquelle :
c) une couche tampon de type N fortement dopée (14) ou
d) pas de telle couche;
et une couche de dérivation de type N faiblement dopée (2),
2) implantation de dopants de type P dans une couche de surface de ladite couche de dérivation pour former une première sous-couche de base de type P fortement dopée (3),
3) croissance épitaxiale d'une seconde sous-couche de base de type P faiblement dopée (4) au-dessus de ladite première sous-couche de base,
4) implantation de dopants de type N dans une couche de surface de ladite seconde sous-couche de base pour former une couche de région source de type N fortement dopée (6),
5) usinage par gravure à l'acide de ladite seconde sous-couche de base à une distance latérale de ladite couche de région source pour former un mur (5) s'étendant jusqu'à la couche de dérivation,
6) implantation de dopants de type N dans la seconde sous-couche de base à une distance latérale de ladite couche de région source, en contact avec ledit mur et dans ledit mur pour former une couche supplémentaire de type N (7) s'étendant depuis la surface de ladite seconde sous-couche de base jusqu'à la couche de dérivation,
7) application d'une couche isolante (8) avec une électrode de porte (9) au-dessus sur la seconde sous-couche de base (4) au moins depuis la couche de région source jusqu'à ladite couche supplémentaire de type N et une source (11) sur ladite couche de région source, les étapes 4) et 5) étant réalisées dans l'un des ordres suivants : a) 4) puis 5) et b) 5) puis 4).

7. Procédé selon la revendication 6, **caractérisé en ce que** l'étape de gravure 5) est réalisée avant l'étape 4) et les implantations selon les étapes 4) et 6) sont réalisées en même temps en une seule étape de procédé.

8. Procédé de fabrication d'un transistor de SiC présentant une porte isolée et étant :
a) un MISFET ou
b) un IGBT;
comprenant les étapes de :
1) croissance épitaxiale sur l'une et l'autre des couches semi-conductrices de SiC suivantes : une couche de substrat fortement dopée (1) étant :
pour a) de type N et
pour b) de type P, et pour b) au-dessus de laquelle :
c) une couche tampon de type N fortement dopée ou
d) pas de telle couche;
une couche de dérivation de type N faiblement dopée (2), une première sous-couche de base de type P fortement dopée (3) et une seconde sous-couche de base de type P faiblement dopée (4),
2) usinage par gravure à l'acide à travers les deux sous-couches de base jusqu'à ladite couche de dérivation pour former un mur (5) sur lesdites deux sous-couches de base,
3) croissance épitaxiale d'une couche supplémentaire de type N (7) sur ledit mur et sur ladite couche de dérivation latéralement jusqu'auxdites sous-couches de base afin que cette couche supplémentaire de type N présente une surface supérieure proche de ladite seconde sous-couche de base sensiblement au même niveau que la surface supérieure de ladite seconde sous-couche de base,
4) implantation de dopants de type N dans une couche de surface de ladite seconde sous-couche de base (4) pour former une couche de région source de type N fortement dopée (6) séparée latéralement de la couche supplémentaire de type N (7),
5) application d'une couche isolante (8) avec une électrode de porte (9) au-dessus sur ladite seconde sous-couche de base au moins depuis la couche de région source jusqu'à ladite couche supplémentaire de type N et une source (11) sur ladite couche de région source, l'étape 4 étant réalisée au choix a) après les étapes 2) et 3), b) avant les étapes 2) et 3) ou c) après l'étape 2) mais avant l'étape 3).

9. Procédé selon l'une quelconque des revendications 6 à 8, **caractérisé en ce que** ladite couche supplémentaire de type N (7) est fabriquée fortement dopée lors de la création.

10. Procédé selon l'une quelconque des revendications 6 à 9, **caractérisé en ce qu'**il comprend l'étape d'implantation de dopants de type P dans une couche de surface de ladite seconde sous-couche de base (4) pour former une couche supplémentaire de type P fortement dopée (15) située latéralement du côté opposé à la couche de région source relativement audit mur, et **en ce que** la source (11) est appliquée aussi en contact avec cette couche supplémentaire de type P.

11. Procédé selon l'une quelconque des revendications 6 à 9, **caractérisé en ce qu'**il comprend l'étape de gravure à travers ladite seconde sous-couche de base(4) jusqu'à la première (3) latéralement du côté opposé à la couche de région source relativement audit mur, et **en ce que** la source (11) est appliquée aussi en contact avec la première sous-couche de base dans cette tranchée.

12. Procédé selon la revendication 6, **caractérisé en ce que** a) du bore ou b) de l'aluminium est implanté comme dopant de type P à l'étape 2).
